# EUROPEAN PATENT APPLICATION

(11) **EP 0 878 987 A1**
(43) Date of publication of application: **18.11.1998**
(21) Application number: 98302731.9
(22) Date of filing: 08.04.1998
(51) Int. Cl.: H05K 3/40, H05K 3/00

(54) **Printed circuit board**

(30) Priority: 12.05.1997 JP 121043/97
(71) Applicant: ALPS ELECTRIC CO., LTD., Ota-ku Tokyo 145 (JP)
(72) Inventor: Inoue, Yoshitaka, Soma-shi, Fukushima-ken (JP)
(74) Representative: Kensett, John Hinton

(57) **Abstract**

A printed circuit board comprises, an insulating board (1) having side through holes (3) formed contiguous to divided end faces (2) of the board, land portions (5) formed of copper foil or the like on the surface of the insulating board (1), and conductors (4) of conductive materials formed respectively on the inner peripheral surfaces of the side through holes (3), wherein the land portions (5) are respectively conducted electrically with the conductors on the insulating board (1), and the land portions (5) have side ends (5a) positioned near and away from the divided end faces (2).

## Description

The present invention relates to a printed circuit board for use in an electronic device such as a high-frequency device of television.

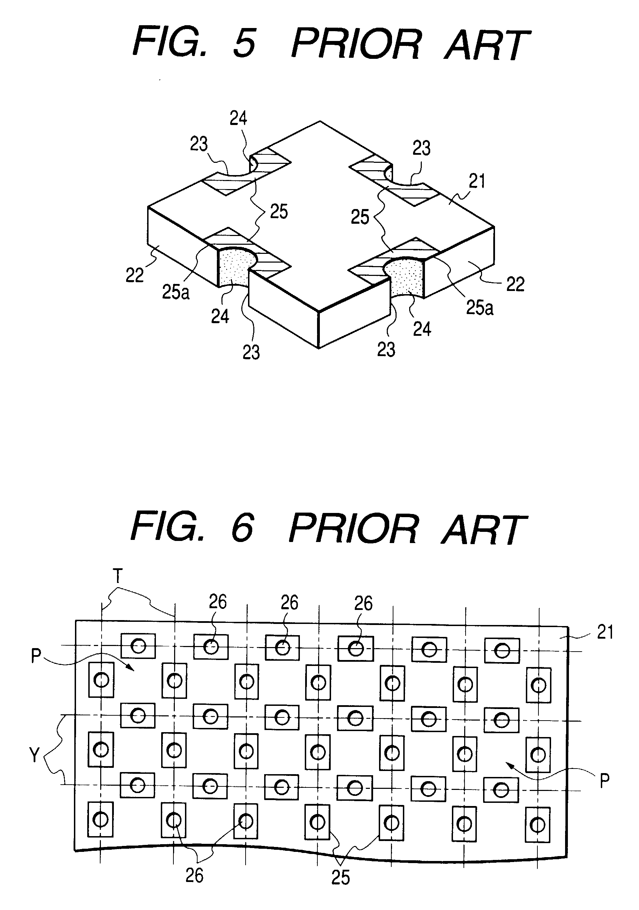

According to a printed circuit board used in a conventional electronic device, as shown in Fig. 5, an insulating board 21 is formed with side through holes 23 adjacent to divided end faces 22, and a conductor 24, which is copper plating for example, is formed on the inner peripheral surface of each side through hole 23.

On the upper and lower surface portions of the insulating board 21 around each side through hole 23 is formed a land portion 5 which is in conduction with the associated conductor 24. Side ends 25a of the land portions 25 are flush with the divided end faces 22.

The printed circuit board, which is a small piece, is placed on a mother board (not shown) of the electronic device and is connected to printed wiring of the mother board by soldering the land portions 25 and the conductors 24 to the printed wiring.

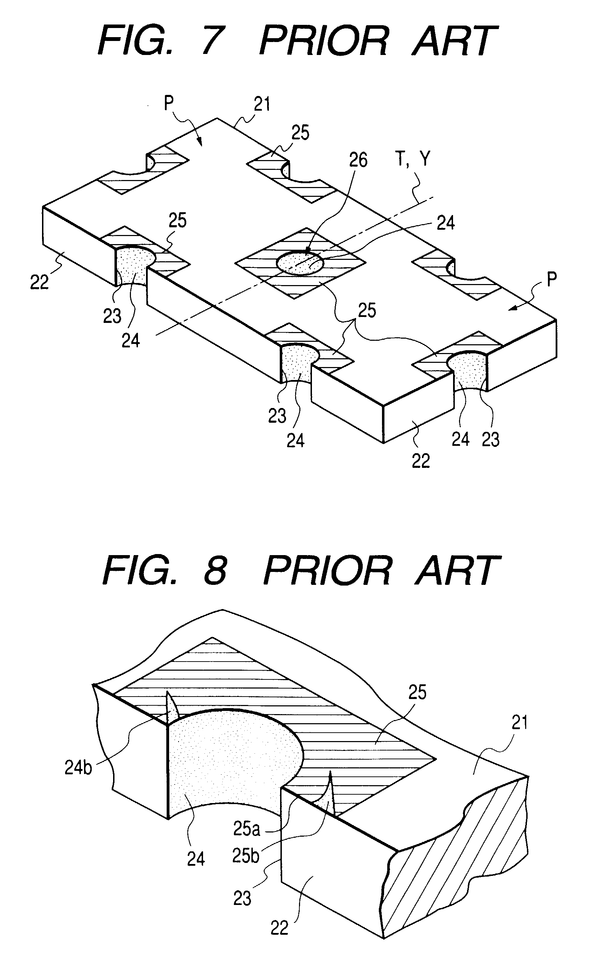

The printed circuit board which is a small piece is obtained by cutting from a large-sized printed circuit board. Now, with reference to Figs.6 and 7, a description will be given of how to fabricate such a small-piece printed circuit. As shown in Fig. 6, in a large-sized insulating board 21 are formed a plurality of holes 26 for side through holes on column lines T and on row lines Y respectively, and the lines T and Y extending at predetermined intervals.

Conductors 24 are formed respectively on the inner peripheral surfaces of the holes 26, and rectangular land portions 25 are formed on the upper and lower surface portions of the insulating board 21 so as to respectively surround the holes 26 and in conduction with the conductors 24. The large-sized printed circuit board is thus constituted.

The small-sized printed circuit board is formed by a portion P surrounded with column lines T and row lines Y. First, using a cutter (not shown), the large-sized printed circuit board is cut along the column lines T and is then cut along the row lines Y, whereby the small-piece printed circuit board referred to above is obtained.

In the conventional printed board, the side ends 25a of each land portion 25 are flush with the associated divided end face 22 which is a cut face, so that, after the cutting, burr 25b is formed at a side end 25a of the land portion 25 by the land portion, as shown in Fig. 8.

Further, at an end portion of each side hole 23 there occurs burr 24b in a connected state of the cut conductor 24 to the land portion 25.

When such a printed circuit board is placed on and soldered to a motor board, it will float from the mother board because of presence of the burrs 24b and 25b. Consequently, not only the soldering is not effected satisfactorily, but also the burrs 24b and 25b come into contact with and are soldered to the adjacent printed wiring, thus causing erroneous wiring.

Moreover, in the case of the conventional large-sized printed circuit board, it is required to cut each land portion 25 which is formed by copper foil for example, with the result that the service life of the cutter is short and the cost increases.

According to a first solution adopted by the present invention to solve the above-mentioned problems, there is provided a printed circuit board comprising, an insulating board having side through holes formed contiguous to divided end faces of the board, land portions formed of copper foil or the like on the surface of the insulating board, and conductors of conductive materials formed respectively on the inner peripheral surfaces of the side through holes, the land portions being respectively conducted electrically with the conductors on the insulating board, and the land portions having side ends positioned near and away from the divided end faces.

According to a second solution adopted by the present invention to solve the foregoing problems of the prior art, there is provided a printed circuit board comprising, an insulating board, a plurality of holes formed in the insulating board, conductors of conductive materials formed respectively on the inner peripheral surfaces of the holes, and a pair of land portions each formed by copper foil or the like around each of the holes, the holes being formed in columns and rows at predetermined intervals, and the paired land portions being formed around each of the holes formed in at least one of the columns and rows and being opposed to each other with respect to land cut-off portions provided on a line joining the centers of the plural holes positioned in any of the columns or rows.

Embodiments of the invention will now be described by way of example only, with reference to the accompanying drawings, in which;
Fig. 1 is an enlarged perspective view of a printed circuit board according to the present invention;
Fig. 2 is a partial plan view of a large-sized printed circuit board used in the present invention;
Fig. 3 is an enlarged perspective view for explaining a method for manufacturing the printed circuit board according to the present invention;
Fig. 4 is an enlarged perspective view of a principal portion of the printed circuit board according to the present invention;
Fig. 5 is an enlarged perspective view of a conventional printed circuit board;
Fig. 6 is a partial plan view of a conventional large-sized printed circuit board;
Fig. 7 is an enlarged perspective view for explaining a method for manufacturing the conventional printed circuit board; and
Fig. 8 is an enlarged perspective view of a principal portion of the conventional printed circuit board.

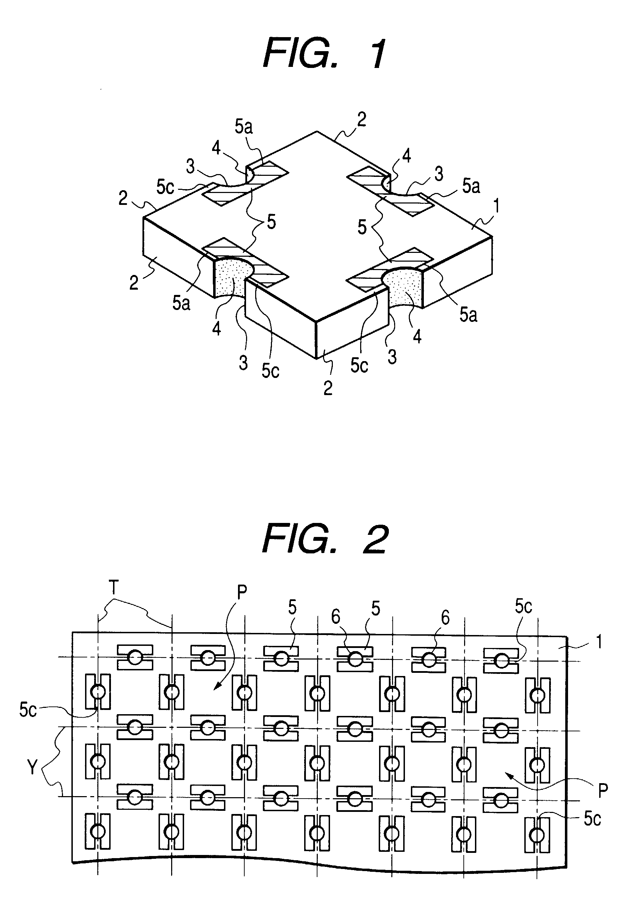

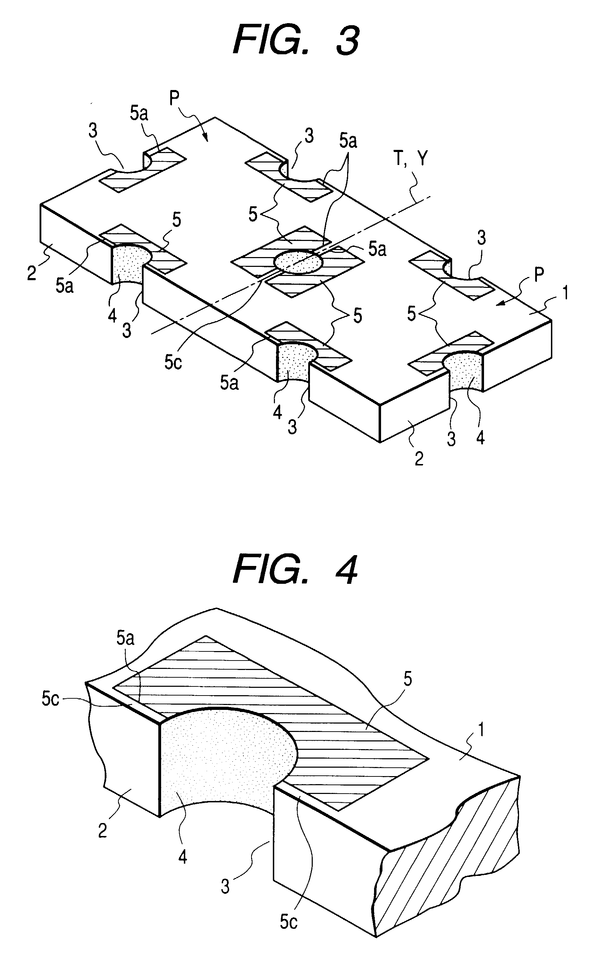

A printed circuit board for use in an electronic device according to the present invention will be described below with reference to the accompanying drawings, in which Fig. 1 is an enlarged perspective view of a printed circuit board embodying the present invention, Fig. 2 is a partial plan view of a large-sized prince circuit board used in the present invention, Fig. 3 is an enlarged perspective view for explaining a method for manufacturing the printed circuit board embodying the invention, and Fig. 4 is an enlarged perspective view of a principal portion of the printed circuit board embodying the invention.

As shown in Fig. 1, a square insulating board 1 formed of a synthetic resin or the like has divided peripheral end faces 2, and side through holes 3 are formed respectively in the divided end faces 2 in an contiguous relation thereto. An electric conductor 4, which is copper plating for example, is formed on the inner peripheral surface of each side through hole 3.

On the upper and lower surface portions of the insulating board 1 around each side through hole 3 are formed land portions 5 formed by copper foil for example and conducted with the conductor 4. Side ends 5a of each land portion 5 positioned near each divided end face 2 are spaced away from the end face 2 through land cut-off portions 5c.

The printed circuit board which is a small piece is placed on a mother board (not shown) of the electronic device and is connected to the mother board by soldering the land portions 5 and conductors 4 to printed wiring of the mother board.

The printed circuit board which is a small piece is fabricated by cutting from a large-sized printed circuit board. A method for fabrication will now be described with reference to Figs.2 and 3. On a large-sized insulating board 1 are formed column lines T and row lines Y at predetermined intervals, and a plurality of side through holes 6 are formed on the column and row lines T,Y. The column lines T are lines joining the centers of column holes 6, while the row lines Y are lines joining the centers of row holes 6.

Conductor 4 is formed on the inner peripheral surface of each hole 6, and a pair of rectangular land portions 5 conducted with the conductor 4 are formed respectively on the upper and lower surfaces of the insulating board 1 around the hole 6.

On the line T joining the centers of column holes 6 are formed land cut-off portions 5c, while on the line Y connecting the centers of row holes 6 are formed land cut-off portions 6c, and the paired land portions 5 are opposed to each other on both sides of the land cut-off portions, to constitute a large-sized printed circuit board.

The printed circuit board of a small piece referred to above is formed by a portion surrounded with column lines T and row lines Y. Using a cutter (not shown), the large-sized printed circuit board is cut first along the column lines T and then cut along the row lines Y to afford the printed circuit board of a small piece.

In the printed circuit board of a small piece thus formed, as shown in Fig. 4, the side ends 5a of each land portion 5 are spaced apart from the associated end face 2 as a cut face because of presence of the land cut-off portions 5c and hence are not cut by the cutter, thereby there is no burr of the land portion. Although the conductor formed on the inner surface of each side through hole 3 is cut by the cutter, the resulting chips are separated because the land cut-off portions 5c prevent connection to the land portion 5.

Although in the printed circuit board of a small piece according to the above embodiment the side through holes 3 are formed respectively in the four divided end faces 2, only one divided end face 2 may be formed with such a side through hole 3, or a plurality of side through holes 3 may be formed in one end face 2. Further, the land cut-off portions 5c may be provided on either the center lines T or the center lines Y.

Further, the present invention is also applicable to a multi-layer printed circuit board formed by laminating a plurality of such printed circuit boards as described above.

According to the printed circuit board of the present invention, as set forth above, since the side ends 5a of each land portion 5 are spaced apart through land cut-off portions 5c from the associated end face 2 as a cut face, burr is formed neither by the land portion nor by the conductor 4 and hence there does not occur any erroneous wiring, thus ensuring a satisfactory soldering.

Moreover, since land cut-off portions 5c are formed on the center lines T of column holes or on the center lines Y of row holes, the cutter does not cut the land portions and hence its service life can be prolonged, leading to reduction of the cost.

## Claims

1. A printed circuit board comprising:
an insulating board having side through holes formed contiguous to divided end faces of the board;
land portions formed of copper foil or the like on the surface of said insulating board; and
conductors of conductive materials formed respectively on the inner peripheral surfaces of said side through holes,
said land portions being respectively conducted electrically with said conductors on said insulating board, and
side ends of said land portions positioned near from said divided end faces are away from said divided end faces.

2. A printed circuit board comprising
an insulating board;
a plurality of holes formed in said insulating board;
conductors of conductive materials formed respectively on the inner peripheral surfaces, of said holes; and
a pair of land portions each conducted electieally with said conductors and formed by copper foil or the like around each of said holes
said holes being formed in columns and rows at predetermined intervals, and
said paired land portions being formed around each of said holes formed in at least one of said columns and rows and being opposed to each other with respect to land cut-off portions provided on a line joining the centers of said plural holes positioned in any of said columns or rows.
